(19) Europäisches Patentamt
European Patent Office
Office européen des brevets

(11) EP 1 432 049 A2

(12) # EUROPEAN PATENT APPLICATION

(43) Date of publication:
**23.06.2004 Bulletin 2004/26**

(51) Int Cl.[7]: **H01L 51/20**, H01L 51/40

(21) Application number: **03090436.1**

(22) Date of filing: **15.12.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **17.12.2002 KR 2002080769**
**19.06.2003 KR 2003039944**

(71) Applicant: **Samsung SDI Co., Ltd.**
**Suwon-si, Gyeonggi-do (KR)**

(72) Inventors:
- **Kim, Mu-Hyung**
  **Paldal-gu, Suwon-City Gyeonggi-do (KR)**
- **Kwon, Jang-Hyuk**
  **Jangan-gu, Suwon-city Gyeonni-do (KR)**
- **Park, Joon-Young**
  **Seocho-gu Seoul (KR)**
- **Kang, Tae- Min**
  **Paldal-gu, Suwon-city Gyeonggi-do (KR)**
- **Chin, Byung-Doo**
  **Bundang-gu, Seongnam-city Gyeonggi-do (KR)**
- **Kim, Jae-Jung, 101-502, Samjeong-Seonbi**
  **Yongin-city Gyeonggi-do (KR)**
- **Song, Myung-Won**
  **Suwon-city Gyeonggi-do (KR)**
- **Suh, Min-Chul**
  **Bundang-gu, Seongnam-city Gyeonggi-do (KR)**
- **Lee, Seong-Taek**
  **Paldal-gu, Suwon-city Gyeonggi-do (KR)**

(74) Representative:
**Hengelhaupt, Jürgen D., Dipl.-Ing. et al**
**Gulde Hengelhaupt Ziebig & Schneider,**
**Schützenstrasse 15-17**
**10117 Berlin (DE)**

(54) **Donor film for low molecular full color organic electroluminescent device using laser induced thermal imaging method**

(57) A low molecular weight full color organic electroluminescent device and a method to fabricate the low molecular weight full color organic electroluminescent device enable scale-up and mass-production of an organic electroluminescent device of high resolution by providing a donor film of a low molecular weight full color organic electroluminescent device, the donor film including a substrate film; a photothermal conversion layer formed on the upper part of the substrate film; and a transfer layer formed on the upper part of the photothermal conversion layer and formed of a low molecular weight material. A part of the transfer layer that is irradiated and heated by a laser is separated from the photothermal conversion layer according to a change of an adhesion force of the transfer layer with the photothermal conversion layer, while part of the transfer layer which is not irradiated by the laser is fixed to the photothermal conversion layer.

EP 1 432 049 A2

## Description

CROSS-REFERENCE TO RELATED APPLICATIONS

This application claims the benefit of Korean Patent Application No. 2002-80769, filed December 17, 2002, and Korean Patent Application No. 2003-39944 filed on June 19, 2003, the disclosure of which is hereby incorporated herein by reference in its entirety.

BACKGROUND OF THE INVENTION

1. Field of the Invention

The present invention relates to a donor film for a low molecular weight full color organic electroluminescent device and a method for fabricating a low molecular weight full color organic electroluminescent device using the same, more particularly, to a donor film used for forming an organic layer of an organic electroluminescent device and a method for fabricating a low molecular weight full color organic electroluminescent device fabricated by using the same.

2. Description of the Related Art

Generally, an organic electroluminescent device consists of anode and a cathode, and various layers, including a hole injection layer, a hole transport layer, an emitting layer, an electron transport layer and an electron injection layer. Organic electroluminescent display devices are typically divided into low molecular weight organic electroluminescent display devices and high molecular weight organic electroluminescent display devices, wherein each layer is introduced by vacuum deposition in the case of the low molecular weight organic electroluminescent display device, while an emitting device is fabricated using a spin coating process in the case of the high molecular weight organic electroluminescent display device.

In the case of a single color device, an organic electroluminescent display device using a high molecular weight molecule simply fabricated using a spin coating process has disadvantages in that the efficiency and the life cycle are decreased although the driving voltage is lower compared with an organic electroluminescent display device using a low molecular weight molecule. Furthermore, a full color device in which red, green and blue polymers are patterned has problems in that the emitting characteristics, such as the efficiency and the life cycle, are decreased when using inkjet technology or a laser induced thermal imaging method.

Particularly, most of the single polymer materials are not transferred when patterning them using a laser induced thermal imaging method. A method of forming patterns of a polymer organic electroluminescent display device by the laser induced thermal imaging method is disclosed in Korean Patent No. 1998-51844 and U.S. Patent Nos. 5,998,085, 6,214,520, and 6,114,088.

To apply the thermal transfer method, at least a light source, a transfer film and a substrate are required, and light coming out of the light source is absorbed by a light absorption layer of the transfer film before being converted into thermal energy, so that a transfer layer forming material of the transfer film is transferred to the substrate by the thermal energy to form a desired image as disclosed in U.S. Patent Nos. 5,220,348, 5,256,506, 5,278,023, and 5,308,737.

The thermal transfer method may be used in fabricating a color filter for a liquid crystal display device and forming patterns of an emitting material as disclosed in U.S. Patent No. 5,998,085.

U.S. Patent No. 5,937,272 discloses a method of forming an advanced patterned organic layer from full color organic electroluminescent display device, wherein a donor support that is an organic electroluminescent material coated with a transferable coating material is used in the method. The donor support is heated so that the organic electroluminescent material is transferred onto the recess surface part of the substrate to form a desired colored organic electroluminescent medium in lower pixels, wherein heat or light is applied to the donor film so that the emitting material is vaporized and transferred to the pixels.

U.S. Patent No. 5,688,551 discloses subpixels formed in each pixel region that are formed by transferring an organic electroluminescent material from a donor sheet to a receiver sheet, wherein the transferring process comprises forming the subpixels by transferring an organic electroluminescent material having a sublimation property at a low temperature of about 400 °C or less from the donor sheet to the receiver sheet.

However, technology describing a low molecular weight full color organic electroluminescent display device has not yet been disclosed, although technologies using a laser induced thermal imaging method for high molecular weight organic electroluminescent display device are currently available.

## SUMMARY OF THE INVENTION

Therefore, to solve the foregoing and/or other problems of the related art, it is an aspect of the present invention to provide a donor film for a low molecular weight full color organic electroluminescent display device to mass-produce a low molecular weight full color organic electroluminescent display device and secure a pixel region having a large area, and a method to fabricate a low molecular weight full color organic electroluminescent display device using the same.

To achieve the foregoing and/or other aspects, an embodiment of the present invention provides a donor film for a low molecular weight full color organic electroluminescent display device. The donor film comprises a substrate film, a photothermal conversion layer formed on the upper part of the substrate film, and a transfer layer formed on the upper part of the photothermal conversion layer and formed of a material comprising a low molecular weight material. A part of the transfer layer which is irradiated and heated by the laser is separated from the photothermal conversion layer according to a change of an adhesion force of the transfer layer with the photothermal conversion layer. A part of the transfer layer which is not irradiated by the laser is fixed to the photothermal conversion layer by an adhesion force of the transfer layer with the photothermal conversion layer. An adhesion force between a substrate of the organic electroluminescent display device to which the material comprising the low molecular weight material formed on the transfer layer is transferred and the material comprising the low molecular weight material and the adhesion force between the photothermal conversion layer and the material comprising the low molecular weight material are greater than the adhesive force between the material comprising the low molecular weight material of a laser irradiated region in the transfer layer and the material comprising the low molecular weight material of a laser non-irradiated region. Thus, the material comprising the low molecular weight material of the laser irradiated region and the material comprising the low molecular weight material of the laser non-irradiated region are separated with respect to each other to cause a mass transistion from the photothermal conversion layer to the substrate.

Furthermore, an embodiment of the present invention provides a method to fabricate a low molecular weight full color organic electroluminescent display device comprising forming a first electrode by patterning the first electrode on a substrate; forming one or more first organic film layers on the first electrode formed substrate by a spin coating or a vacuum deposition method; forming an emitting layer to embody full color on a pixel region by a laser induced thermal imaging method; forming one or more second organic film layers on the emitting layer by a spin coating or a vacuum deposition method; and forming a second electrode on the organic film layers.

Furthermore, an embodiment of the present invention provides a method to fabricate a low molecular weight full color organic electroluminescent display device comprising arranging a donor film comprising a low molecular weight organic thin film material comprising a substrate film, a photothermal conversion layer and a low molecular weight organic electroluminescent material layer at a position spaced apart from a substrate in a certain distance at a position where a pixel region of the substrate is formed; irradiating a laser onto the donor film, thus separating the low molecular weight organic thin film material layer into a region in which the pixel region is formed from the donor film so that the low molecular weight organic thin film material layer is adhered to the substrate by a first adhesion force, fixing the low molecular weight organic thin film material layer of a region onto which the laser is not irradiated to the photothermal conversion layer by a second adhesion force, and separating the laser irradiated low molecular weight organic thin film material layer and the laser non-irradiated low molecular weight organic thin film material layer with respect to each other to cause mass transition. Thus, the low molecular weight organic thin film material layer in the pixel region is transferred from the photothermal conversion layer to the substrate since the adhesive force between the laser irradiated low molecular weight organic thin film material layer region and the laser non-irradiated low molecular weight organic thin film material layer is weaker than the first and second adhesion forces; and heat treatment is performed after completing the transfer step.

Additional aspects and/or advantages of the invention will be set forth in part in the description which follows and, in part, will be obvious from the description, or may be learned by practice of the invention.

Furthermore, an embodiment of the present invention provides a low molecular weight full color organic electroluminescent display device fabricated by any fabrication method of the above fabrication methods.

## BRIEF DESCRIPTION OF THE DRAWINGS

These and/or other aspects and advantages of the invention will become apparent and more readily appreciated from the following description of the embodiments, taken in conjunction with the accompanying drawings of which:

Further aspects and advantages of the invention may be more fully understood from the following detailed description taken in conjunction with the accompanying drawings in which:

FIG. 1 is a drawing illustrating a transfer mechanism when transfer patterning an emitting organic film used in an

organic electroluminescent display device using a laser;

FIG. 2 is a cross sectional view schematically showing a structure of a low molecular weight full color organic electroluminescent display device patterned in accordance with ane embodiment of the present invention;

FIG. 3 and FIG. 4 are drawings showing a structure of a donor film for a low molecular weight organic electroluminescent display device according to embodiments of the present invention; and

FIG. 5 is a drawing illustrating a transferring method using a donor film according to an embodiment of the present invention.

DETAILED DESCRIPTION OF THE EMBODIMENTS

Reference will now be made in detail to the embodiments of the present invention, examples of which are illustrated in the accompanying drawings, wherein like reference numerals refer to the like elements throughout. The embodiments are described below to explain the present invention by referring to the figures.

FIG. 1 is a drawing illustrating a transfer mechanism when transfer patterning an emitting organic film used in an organic electroluminescent display device using a laser according to an embodiment of the present invention.

As illustrated in FIG. 1, the organic film S2 is separated from a laser non-receiving part as it is being transferred to a substrate S3 after an organic film S2 adhered to a substrate S1 is separated from the substrate S1 by action of a laser.

Factors affecting transfer characteristics are first an adhesion force (W12) between substrate S1 and film S2, an adhesive force (W22) between the films and a second adhesion force (W23) between the film S2 and the substrate S3.

The first and second adhesion forces and adhesive force may be represented by surface tensions ($\gamma$ 1, $\gamma$ 2, $\gamma$ 3) and interfacial tensions ($\gamma$ 12, $\gamma$ 23) of each layer, as set forth in the following expressions:

$$W12=\gamma 1+\gamma 2-\gamma 12$$

$$W22= 2\gamma 2$$

$$W23= \gamma 2+\gamma 3-\gamma 23.$$

The adhesion force between the films should be less than the adhesion force between each substrate and the film to improve the laser transfer characteristics.

Generally, an organic material is used as a material of each layer in an organic electroluminescent display device, wherein a fine pattern of an emitting layer may be formed by transferring an emitting material from a donor film to the organic electroluminescent display device, thus causing a mass transfer, since the first and the second adhesion forces are greater than an adhesion force in the case of using a low molecular weight material. Even fine patterns of an emitting layer may be formed, and there is less possibility of mis-alignment by transferring the emitting material from the donor film to the organic electroluminescent device.

FIG. 3 and FIG. 4 are drawings showing a structure of a donor film for a low molecular weight organic electroluminescent display device according to embodiments of the present invention.

The donor film 34 has a structure in which a photothermal conversion layer 32 and a transfer layer 33 are applied to a substrate film 31 as illustrated in FIG. 3.

FIG. 3 illustrates a donor film of the most basic structure, wherein a structure of a film may be changed, depending on applications. For example, the donor film may be an antireflection coating treated to prevent characteristics of a transfer layer from deteriorating due to reflection, or a gas-generating layer 35 may be additionally formed in the lower part of the photothermal conversion layer to improve the sensitivity of the film as illustrated in FIG. 4.

The gas-generating layer 35 causes a decomposition reaction when absorbing light or heat so that the gas-generating layer 35 provides a transfer energy by emitting nitrogen gas or hydrogen gas when the gas-generating layer 35 is formed of one material selected from pentaerythritol tetranitrate, trinitrotoluene, etc.

The substrate film 31 is generally formed of a transparent polymer, the polymer may include polycarbonate, polyester, polyethyleneterephthalate, polyethylenenaphthalate, polyestersulfonate, polysulfonate, polyarylate, fluorinated polyimide, fluorinated resin, polyacryl, polyepoxy, polyethylene and/or polystyrene. Polyethylene terephthalate film is a suitable material for the substrate film. A thickness of the substrate film is generally 10 to 500 $\mu$m. The substrate film functions as a supporting film, and a composite multiplayer system may also be used as the substrate film.

The photothermal conversion layer is typically formed of a light absorbing material having a property for absorbing light in the infrared-visible ray range. A film having the desired characteristics includes a metallic film comprising aluminum, aluminum oxide and sulfide and an organic film comprising a polymer to which carbon black, graphite or infrared dye is added, wherein the metallic film having a thickness of 100 to 5,000 A is formed by using electron beam deposition or a sputtering method, and the organic film having a thickness of 0.1 to 10 μm is generally formed by using a general film coating method of extrusion, spin coating or knife coating.

As described above, the transfer layer 33 is generally formed of at least one low molecular weight organic electroluminescent material that is not a high molecular weight material, wherein a transfer layer having a thickness of 100 to 50,000 Å is formed by using a general coating method of extrusion, spin coating, knife coating, vacuum deposition and chemical vapor deposition.

Using materials represented as illustrated in the following Formulas 1 to 12 generally form the low molecular weight organic electroluminescent layer:

Formula 1

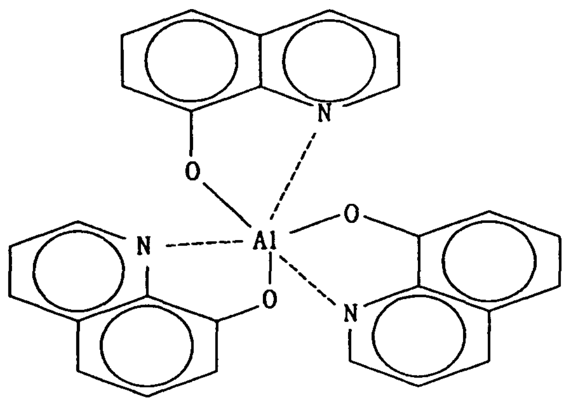

Formula 2

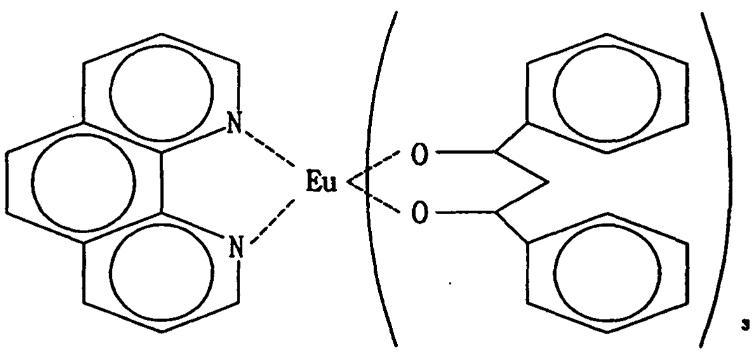

Formula 3

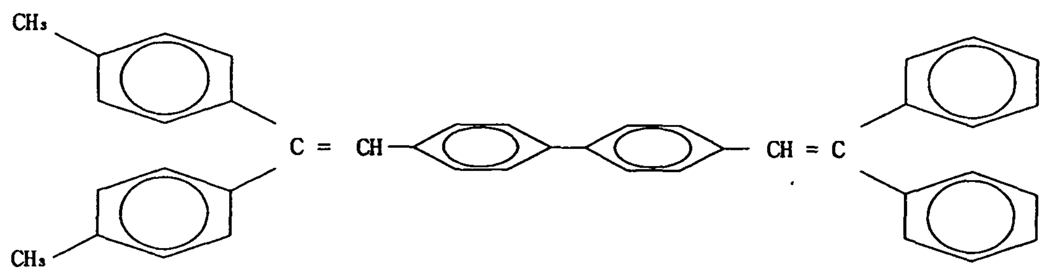

Formula 4

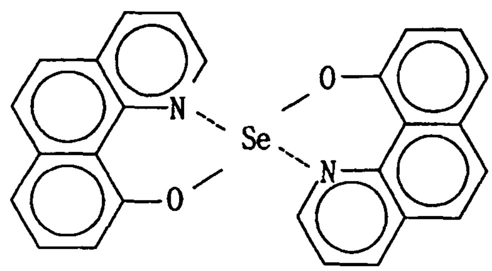

Formula 5

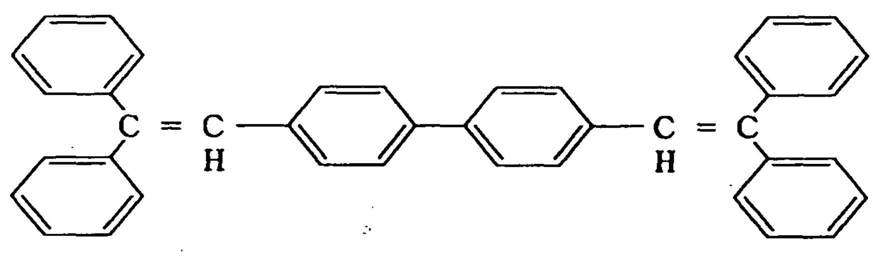

Formula 6

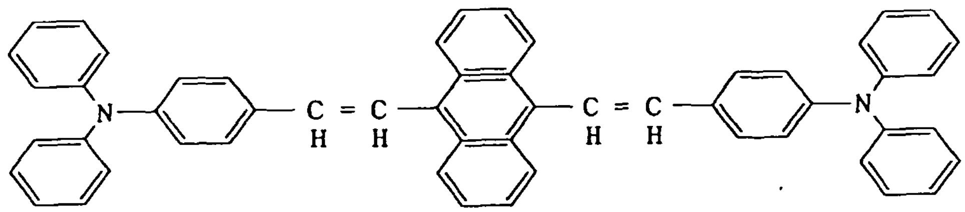

Formula 7

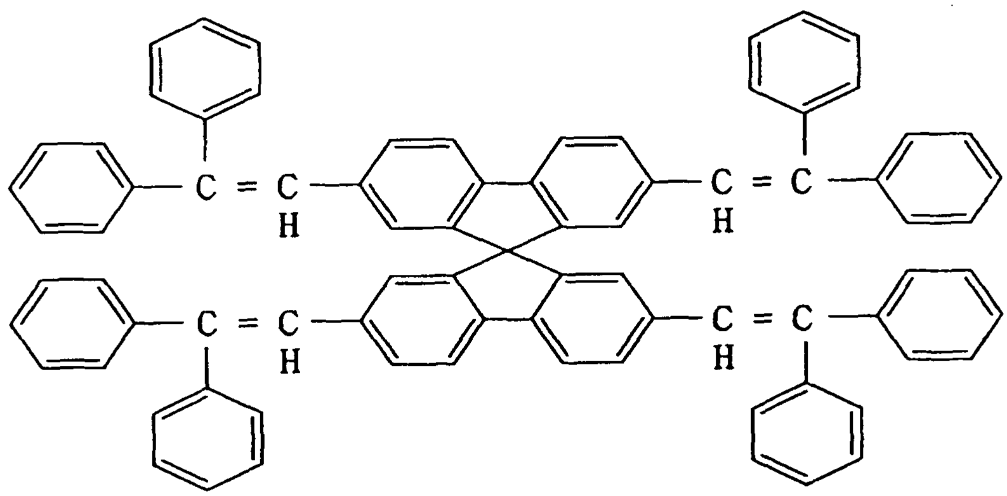

Formula 8

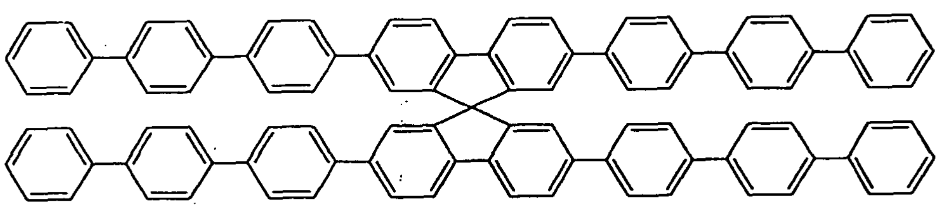

Formula 9

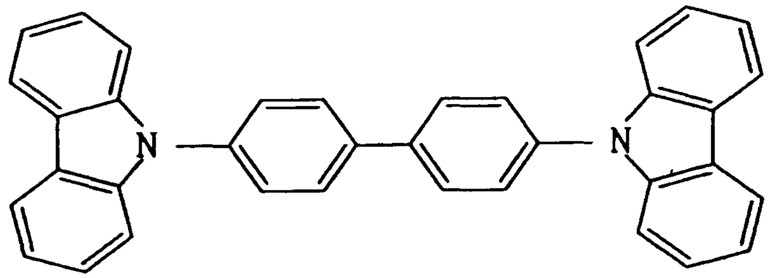

Formula 10

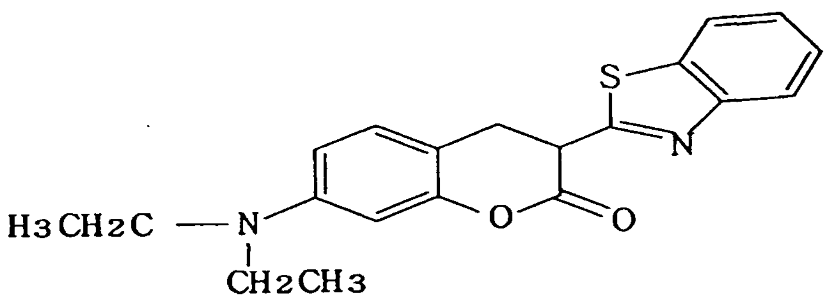

Formula 11

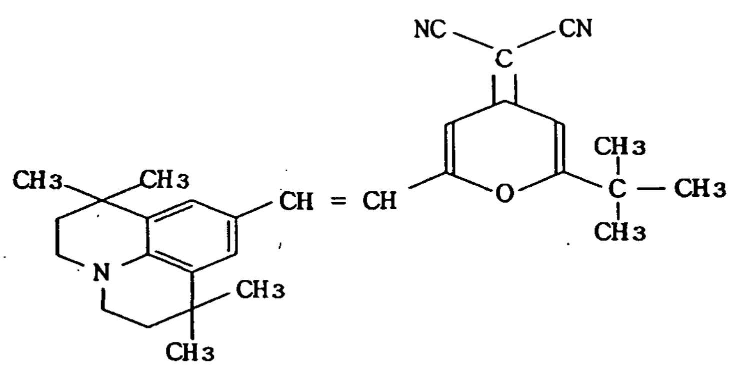

Formula 12

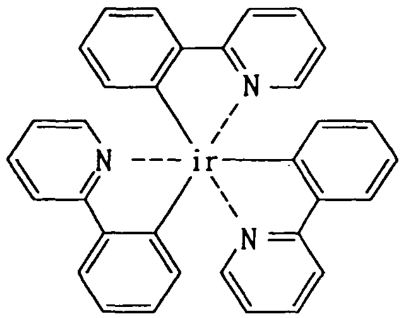

Formula 13

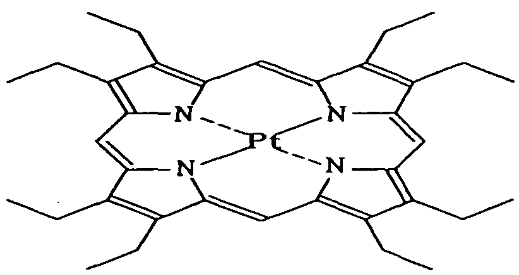

The transfer layer may further comprise at least one layer selected from the group consisting of a hole injection layer, a hole transporting layer, a hole blocking layer and an electron transporting layer.

The hole transmitting layer may be a compound represented as in the following Formulas 14 to 18.

Formula 14

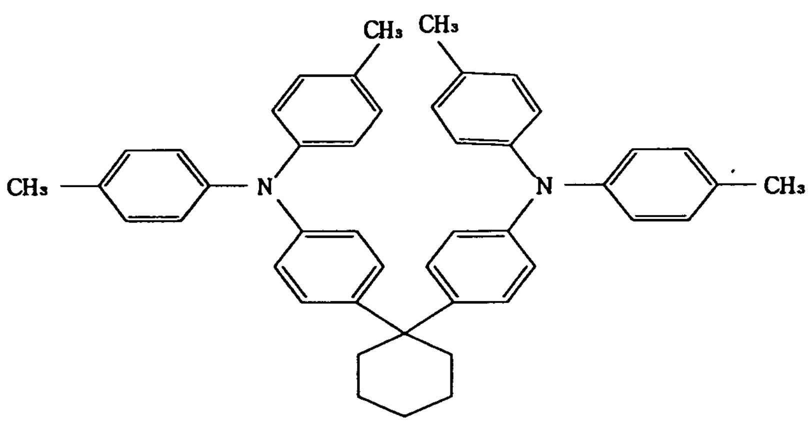

Formula 15

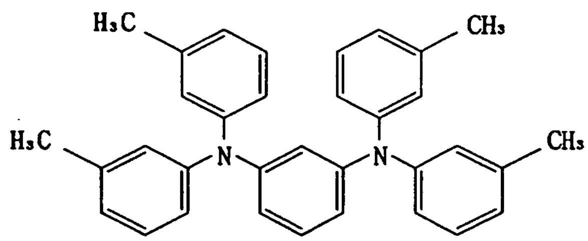

Formula 16

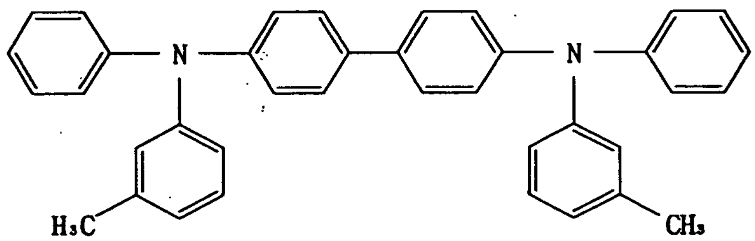

Formula 17

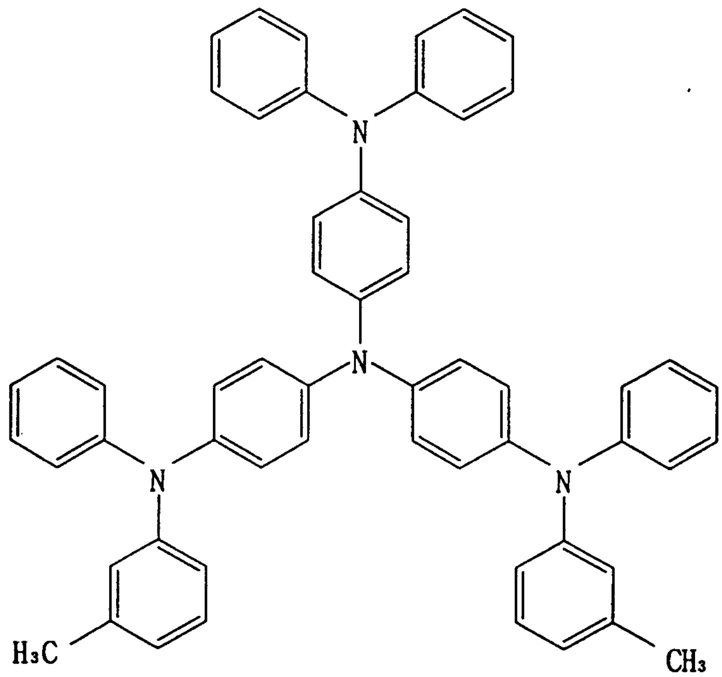

Formula 18

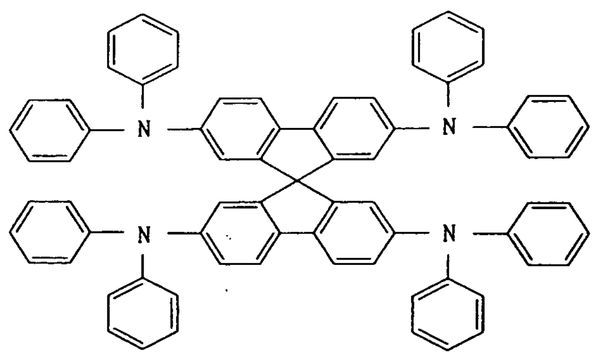

The hole injecting layer may be a compound represented as in the following Formulas 19 to 23.

Formula 19

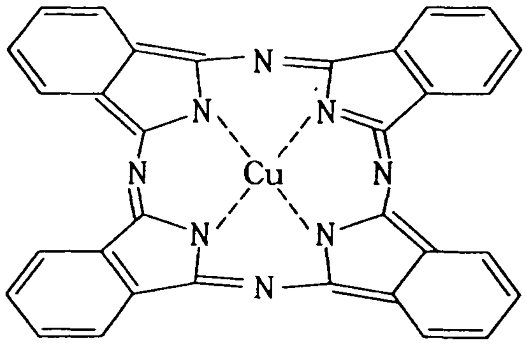

Formula 20

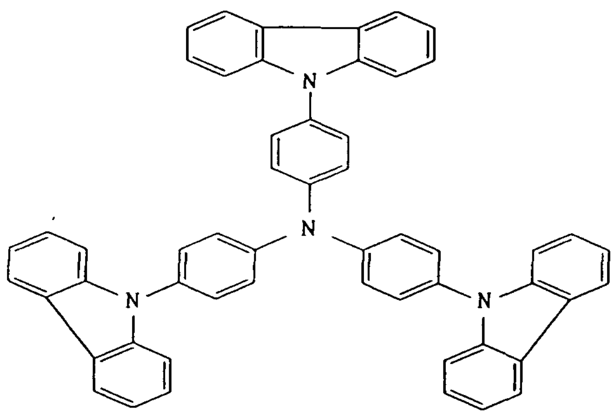

Formula 21

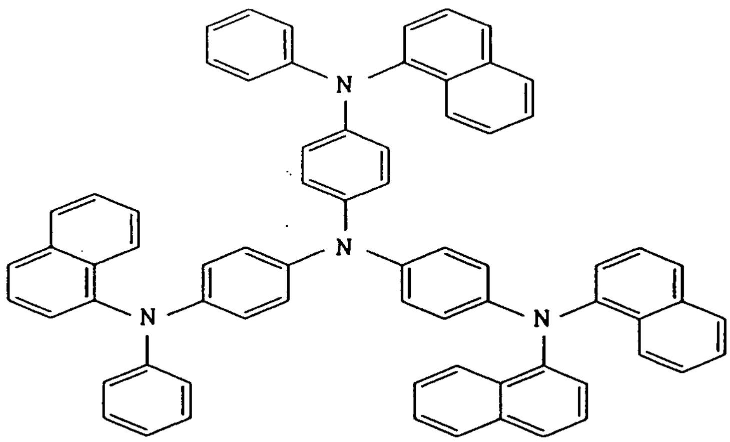

Formula 22

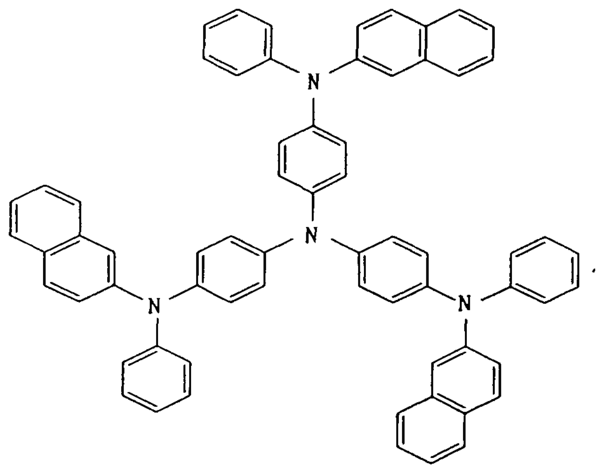

Formula 23

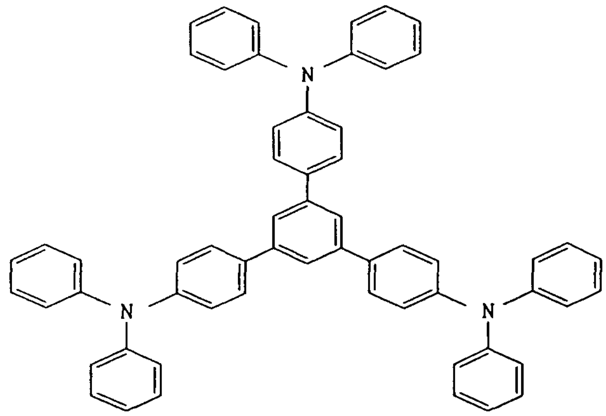

The electron injecting layer may be formed of one selected from the group consisting of 1,3,4-oxadiazole derivative, 1,2,4-triazole derivative, $Alq_3$, Ga complex, and PBD.

The hole blocking layer may be formed of one selected from the group consisting of TAZ, spiro-TAZ, compound represented as in the following Formulas 24 to 26.

Formula 24

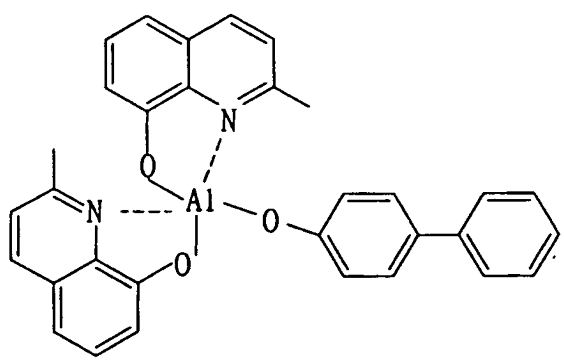

Formula 25

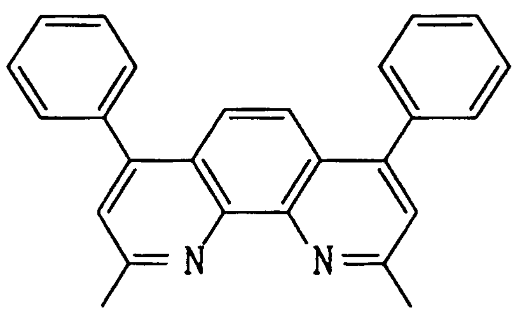

Formula 26

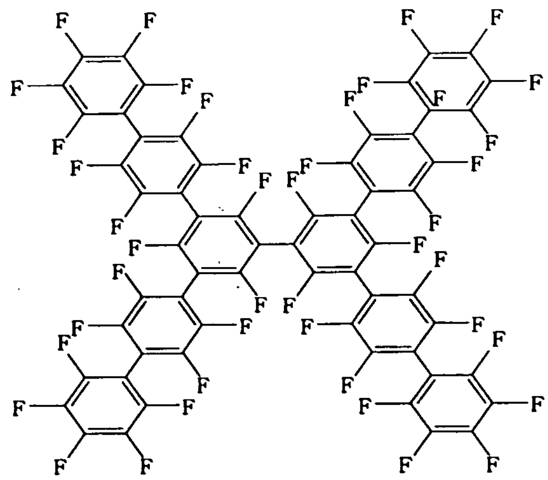

An organic electroluminescent device may be completed by forming an insulating layer on a second electrode layer 25 after forming an organic thin film of a first organic film layer 22, an emitting layer 23 and a second organic film layer 24 according to the above method and forming the second electrode layer 25 oppositely directed to the first electrode layer 21 on the second organic film layer 24.

On the other hand, an embodiment of the present invention provides a method to fabricate a low molecular weight full color organic electroluminescent device by a laser induced thermal imaging method using a low molecular weight molecule as an emitting material to form the emitting layer.

FIG. 2 is a cross sectional view, schematically showing a structure of a low molecular weight full color organic electroluminescent device patterned in accordance with an embodiment of the present invention. Referring to FIG. 2, an organic electroluminescent device according to an embodiment of the present invention may be formed by patterning the first electrode layer 21 on a semiconductor substrate 2, wherein the first electrode layer 21 is separated into a pixel defined layer (PDL) or passivation layers.

First, an organic film layer 22 is formed on the first electrode layer 21 after forming the first electrode layer 21.

The first organic film layer 22 may be formed along with the emitting layer 23 and the second organic film layer 24 by a laser induced thermal imaging process or may be formed by itself as described below.

The first organic film layer 22 comprises a hole injection layer and/or a hole transport layer, when the first electrode 21 is the anode. Generally, a low molecular weight organic electroluminescent display device comprises a hole injection layer and a hole transport layer to improve the characteristics of the device.

The hole injection layer and/or the hole transport layer may be formed by spin coating or a deposition method when forming the first organic film layer 22 only.

On the other hand, the first organic film layer 22 comprises one or more layers of the electron transport layer, the hole blocking layer and the electron injection layer when the first electrode 21 is the cathode. Generally, a low molecular weight organic electroluminescent display device comprises an electron transport layer to improve the characteristics of the device as described above, and further comprises a hole blocking layer and/or an electron injection layer.

As mentioned above, the emitting layer 23 may be formed on the first organic film layer formed on the substrate if a first organic film layer is first formed on a substrate. A donor film on which emitting material is formed is prepared by any coating method, including vacuum deposition or spin coating a low molecular weight emitting material on a donor film to transfer the emitting material to manifest red, green and blue colors on the transferring donor film.

The emitting layer may be formed by transferring the emitting material to the prepared donor film using a laser beam so that the low molecular weight emitting material coated on the donor film is patterned on a pixel region on a substrate on which a first organic film layer 22 is formed.

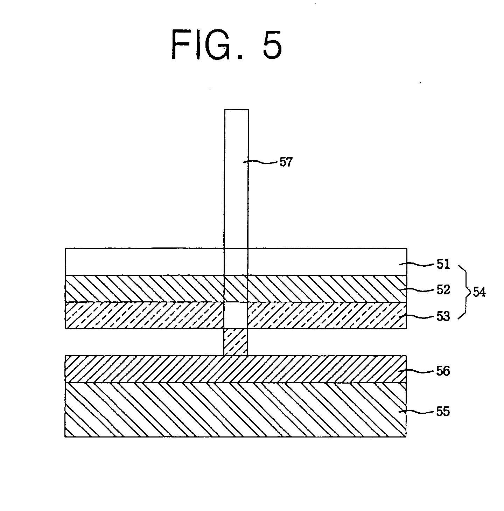

Referring to FIG. 5, a method to form fine patterns of an organic electroluminescent display device according to an embodiment of the present invention is described in detail as follows. FIG. 5 illustrates a transferring method using a donor film according to an embodiment of the present invention. First, a transparent electrode layer 56 is formed on a transparent substrate 55. Separately, a donor film 54 is prepared by sequentially coating a photothermal conversion layer 52 and a transfer layer 53 on a substrate film 51.

The transfer layer is prepared by coating an organic thin film forming material, wherein additives of a desired content may be added to the organic thin film forming material. For example, dopant may be added to increase the efficiency of the emitting layer. Methods to form a transfer layer include film coating methods of vacuum deposition, extrusion, spin coating and knife-coating methods as described above.

The organic thin film forming material may be stacked together with an emitting material, a hole transmitting material and an electron transmitting material when forming first organic film layer 22, an emitting layer 23 and a second organic film layer 24 at the same time.

An energy source 57 may be utilized to irradiate the donor film 54 after arranging the donor film 54 at a position spaced apart from a substrate 55 on which a transparent electrode layer 56 is formed along a predetermined distance.

The energy source 57 activates the photothermal conversion layer 52 by passing through the substrate film 53 via a transferring unit and emits heat by a thermal decomposition reaction. A transferring material may be transferred to a desired pattern and thickness on a substrate 55 in which the transparent electrode layer 56 is formed on the transparent substrate 55 due to the emitted heat.

An energy source used in an embodiment of the present invention includes a laser, a xenon lamp and a flash lamp. The laser is generally used, since the laser provides a desirable transferring effect when a circular or other shaped laser beam is used.

When a laser is used to irradiate the donor film, a hole transporting low molecular weight material and/or an electron transmitting low molecular weight material is separated from the donor film in a region in which the pixel region is formed so that the low molecular weight organic electroluminescent material is adhered to the substrate by a first adhesion force, the low molecular weight organic electroluminescent material of a region onto which laser is not irradiated is fixed to the photothermal conversion layer by a second adhesion force, and the laser irradiated low molecular weight organic electroluminescent material and laser non-irradiated low molecular weight organic electroluminescent material are separated with respect to each other to cause mass transfer. Thus, the low molecular weight organic electroluminescent material in the pixel region is transferred from the photothermal conversion layer to the substrate since the adhesive force between the laser irradiated low molecular weight organic electroluminescent material region and the laser non-irradiated low molecular weight organic electroluminescent material is weaker than the first and second adhesion forces.

The low molecular weight organic electroluminescent material transferred donor film passes through a heat treatment process for annealing and adherence of the transferred material after completing the foregoing transfer process.

Transferring of the transfer material may be performed in one stage or in a plurality of stages. That is, transferring may be made once or several times repeatedly to transfer a thickness of an organic thin film layer to be transferred. For a full color device, R, G, B electroluminescent materials may be transferred repeatedly onto a common hole transporting layer. A hole blocking layer and/or an electron transporting layer may be vacuum deposited as a common layer. However, the transfer material may be transferred in one operation, considering the convenience and the stability of the process.

The second organic film layer 24 may be formed along with the emitting layer or formed continuously after forming the emitting layer only.

The second organic film layer 24 comprises one or more layers selected from an electron injection layer, a hole inhibition layer and an electron transport layer when the first electrode is a cathode. Generally, a low molecular weight organic electroluminescent display device comprises an electron injection layer to improve the device characteristics, as described above, and further comprises a hole blocking layer and/or a electron transport layer, so that a low molecular weight full color organic electroluminescent display device is completed by sealing the second electrode after forming second electrode 25.

The second organic film layer may be formed by spin coating or deposition when separately forming the second organic film layer.

On the other hand, the second organic film layer 24 comprises a hole injection layer and/or a hole transport layer when the first electrode 21 is the anode. A low molecular weight full color organic electroluminescent display device may be completed by sealing the second electrode 25 after forming the second organic film layer and forming the cathode electrode as a second electrode. Spin coating or deposition may be utilized to form the second organic film layer.

The present invention not only obtains a display device of high resolution, but also enables easy mass-production of the low molecular weight organic electroluminescent display device due to facilitated formation of fine patterns of the emitting layer by forming an emitting layer of a low molecular weight full color organic electroluminescent display device only using a laser induced thermal imaging method, without using a fine metal mask for the patterning of the RGB.

Although a few embodiments of the present invention have been shown and described, it would be appreciated by those skilled in the art that changes may be made in this embodiment without departing from the principles and

spirit of the invention, the scope of which is defined in the claims and their equivalents.

## Claims

1. A donor film of a low molecular weight full color organic electroluminescent display device, the dornor film comprising:

    a substrate film;
    a photothermal conversion layer formed on the upper part of the substrate film; and
    a transfer layer formed on an upper part of the photothermal conversion layer and formed of a material comprising a low molecular weight material,

    wherein a part of the transfer layer which is irradiated and heated by a laser is separated from the photothermal conversion layer according to change of an adhesion force of the transfer layer with the photothermal conversion layer,

    while a part of the transfer layer which is not irradiated by the laser is fixed to the photothermal conversion layer by an adhesion force of the transfer layer with the photothermal conversion layer, and

    an adhesion force between a substrate of organic electroluminescent display device to which the material comprising low molecular weight material formed on the transfer layer is transferred and the material comprising low molecular weight material and an adhesion force between the photothermal conversion layer and the material comprising low molecular weight material are greater than an adhesive force between the material comprising a low molecular weight material of a laser irradiated region in the transfer layer and the material comprising a low molecular weight material of a laser non-irradiated region,

    so that the material comprising the low molecular weight material of the laser irradiated region and the material comprising the low molecular weight material of the laser non-irradiated region are separated with respect to each other to cause mass transistion from the photothermal conversion layer to the substrate.

2. The donor film of the low molecular weight full color organic display electroluminescent device of claim 1, wherein the transfer layer comprises at least one low molecular weight electroluminescent material.

3. The donor film of the low molecular weight full color organic display electroluminescent device of claim 2, wherein the low molecular weight organic electroluminescent material comprises at least one material selected from compounds represented by at least one of the following Formulas 1 to 13:

Formula 1

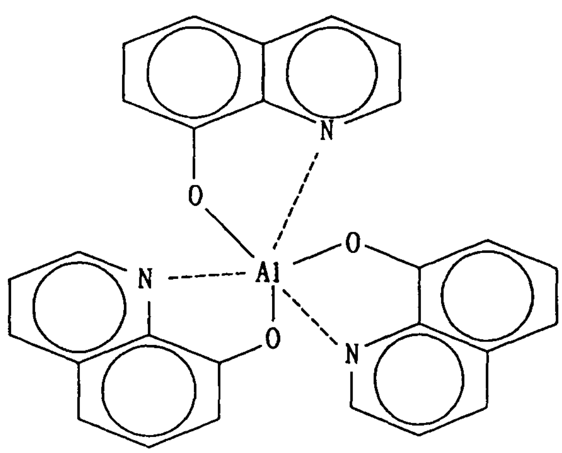

Formula 2

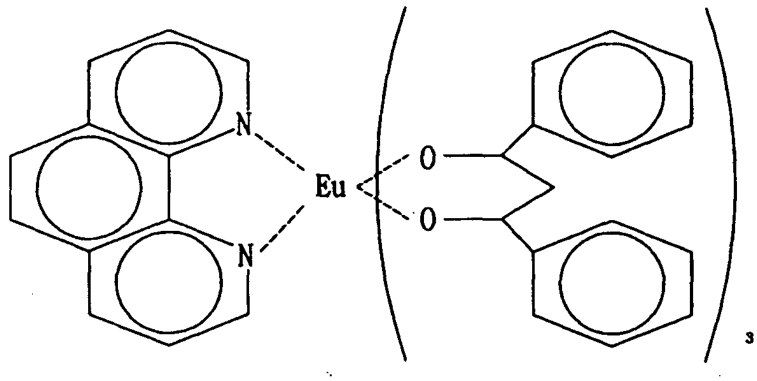

Formula 3

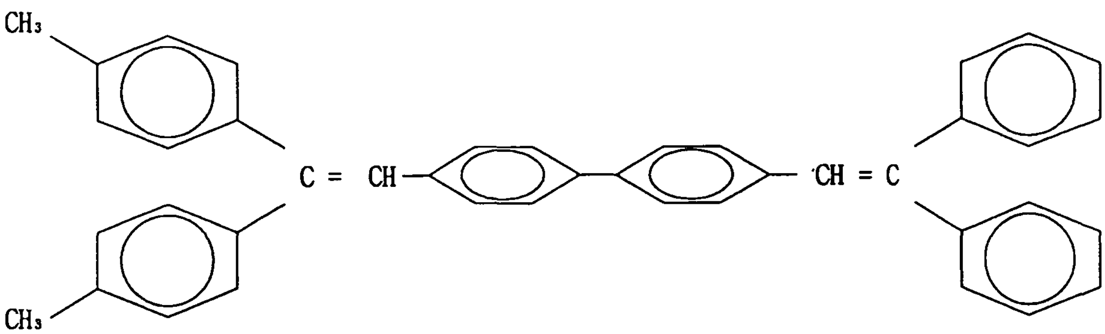

Formula 4

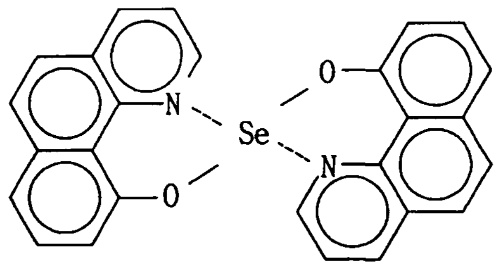

Formula 5

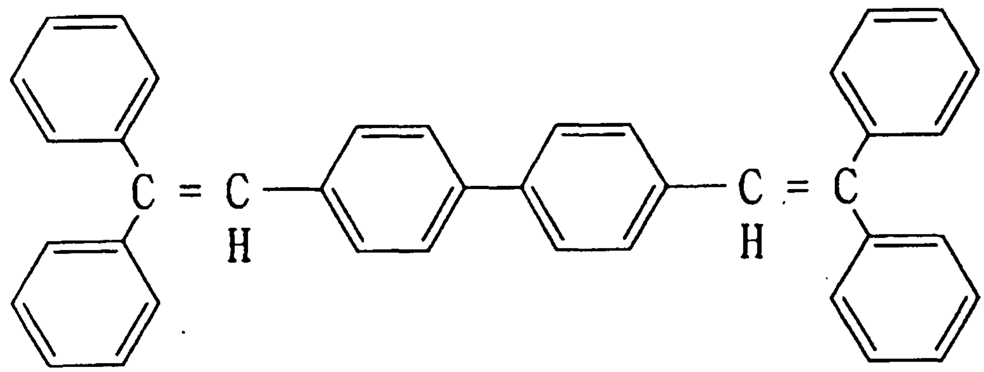

Formula 6

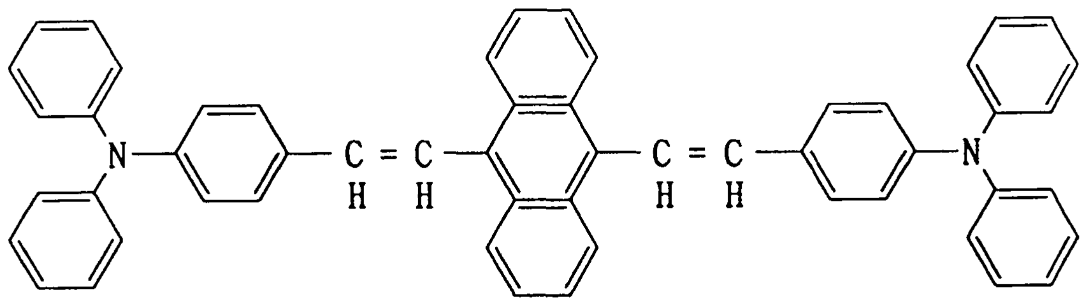

Formula 7

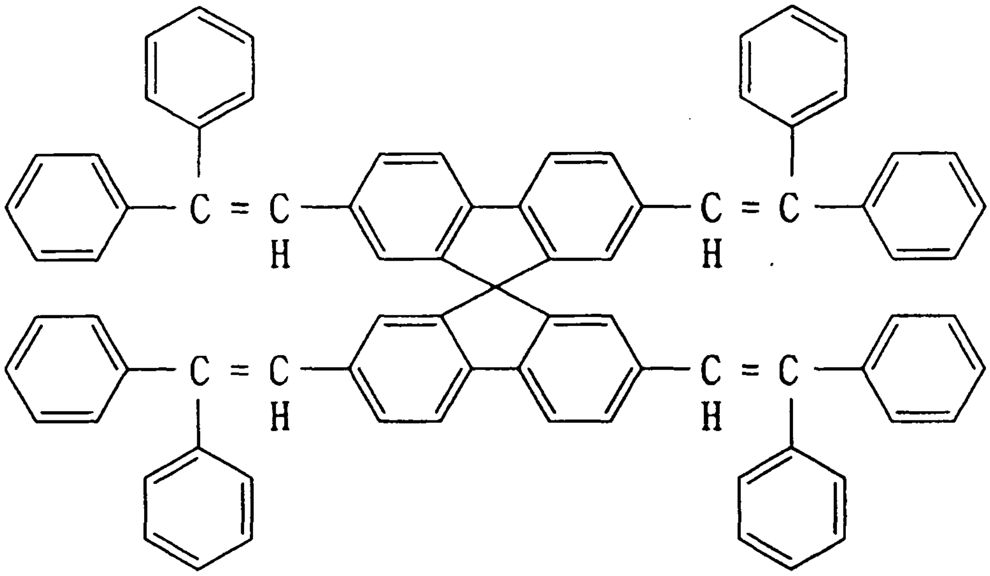

Formula 8

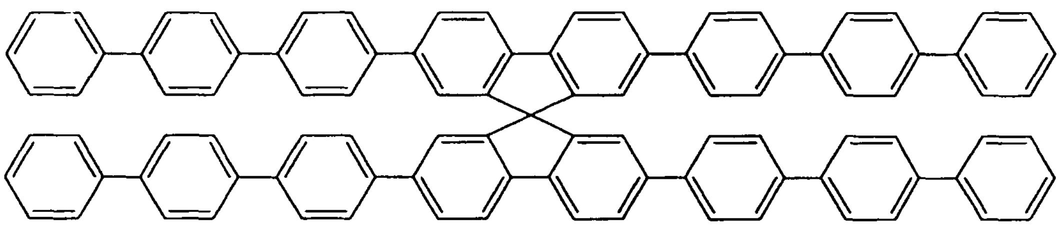

Formula 9

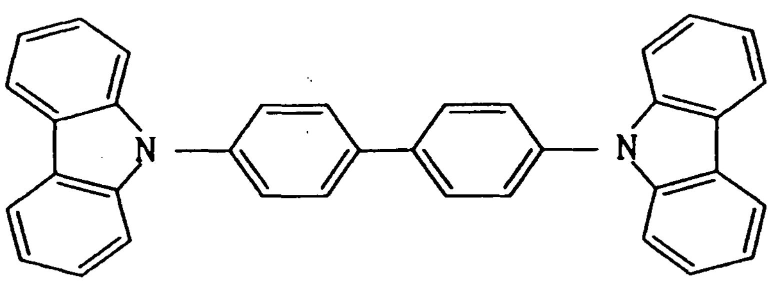

Formula 10

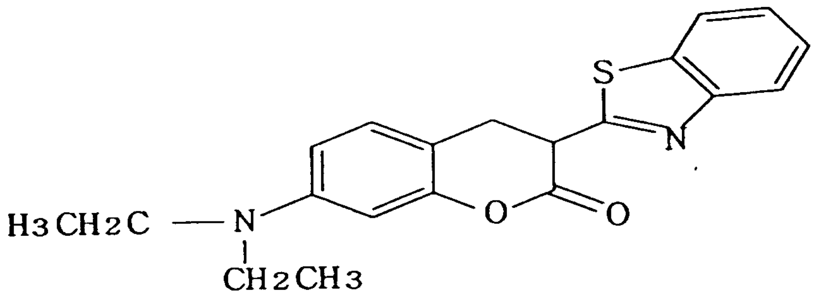

Formula 11

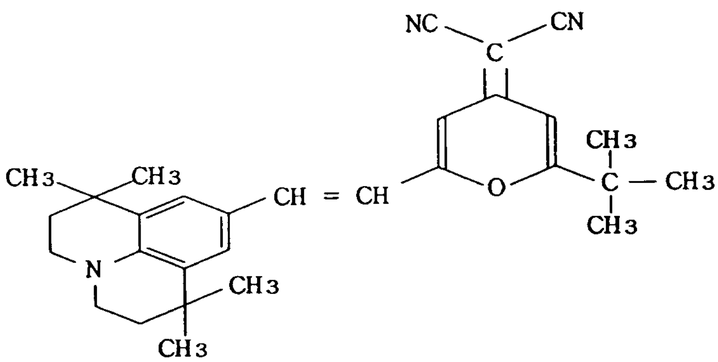

Formula 12

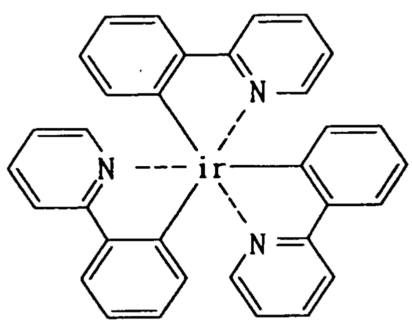

Formula 13

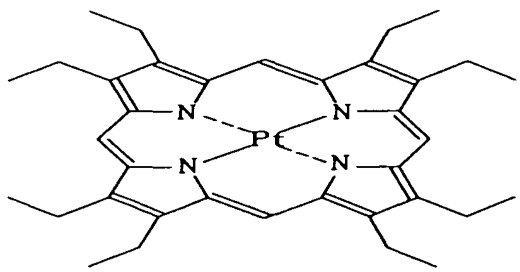

4. The donor film of the low molecular weight full color organic electroluminescent display device of claim 1, wherein the transfer layer further comprises at least one layer selected from the group consisting of a hole injection layer, a hole transporting layer, a hole blocking layer and an electron transporting layer.

5. The donor film of the low molecular weight full color organic electroluminescent display device of claim 4, wherein the hole transmitting layer is a compound represented by at least one of the following Formulas 14 to 18:

Formula 14

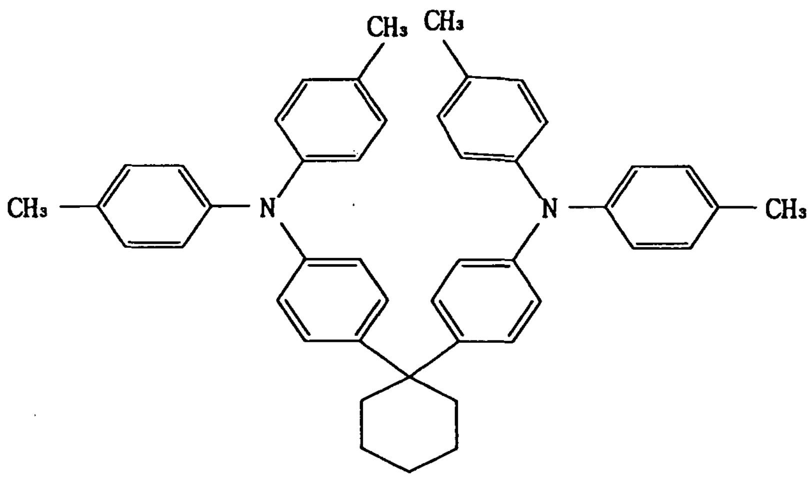

Formula 15

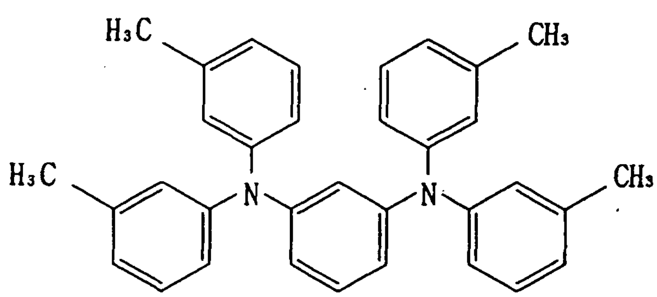

Formula 16

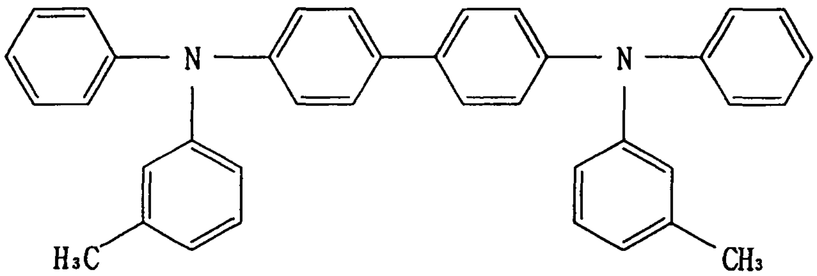

Formula 17

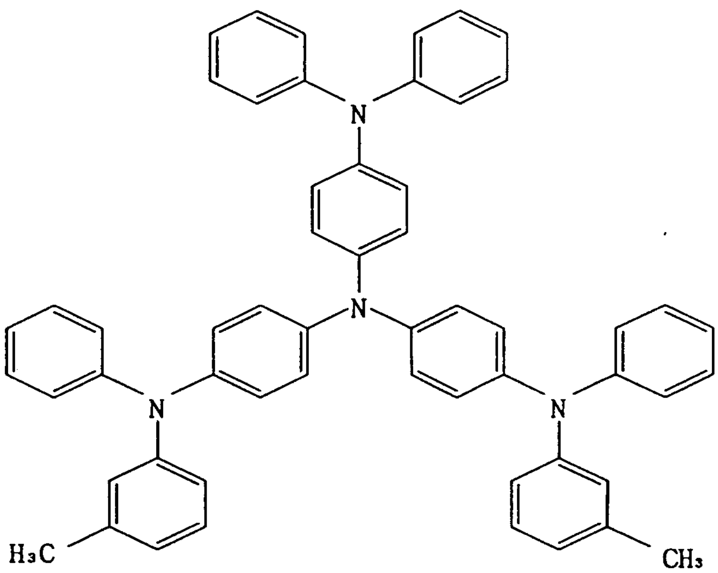

Formula 18

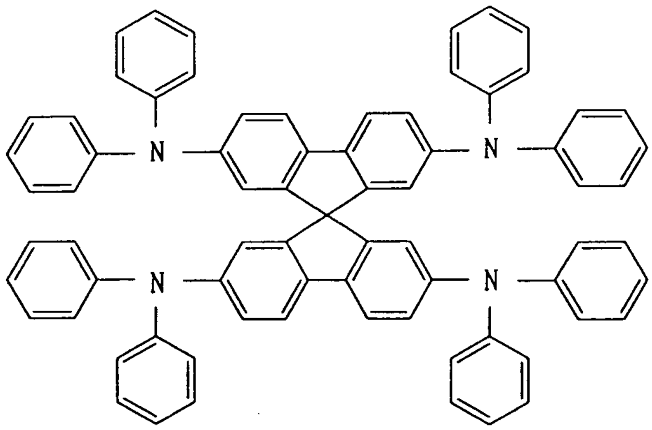

6. The donor film of the low molecular weight full color organic electroluminescent display device of claim 4, wherein the hole injecting layer is a compound represented by at least one of the following Formulas 19 to 23:

Formula 19

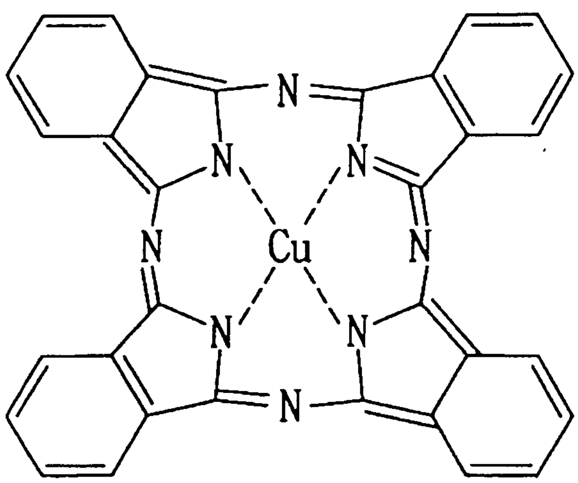

Formula 20

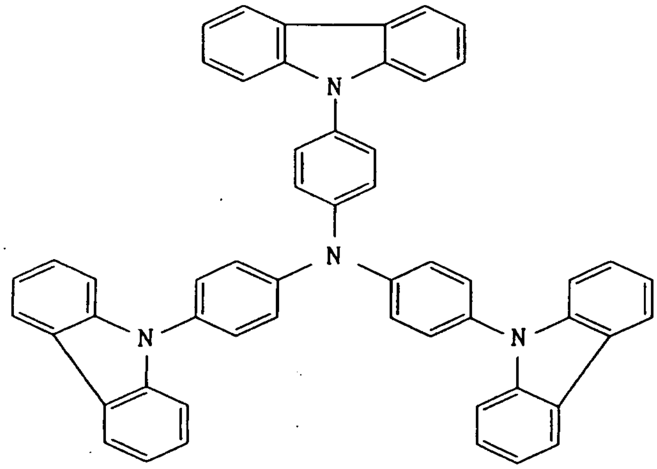

Formula 21

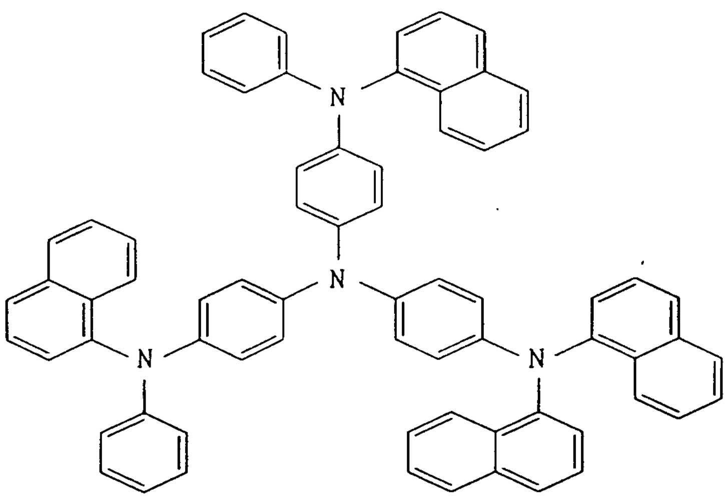

Formula 22

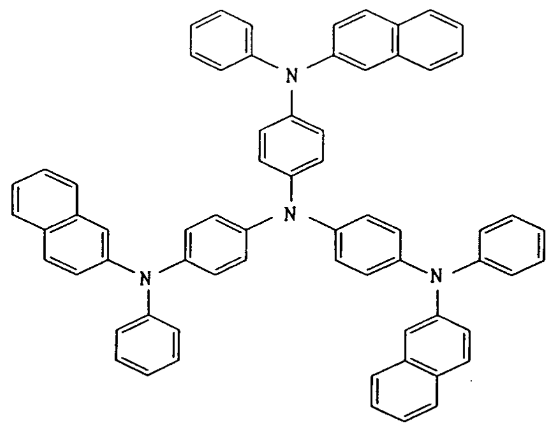

Formula 23

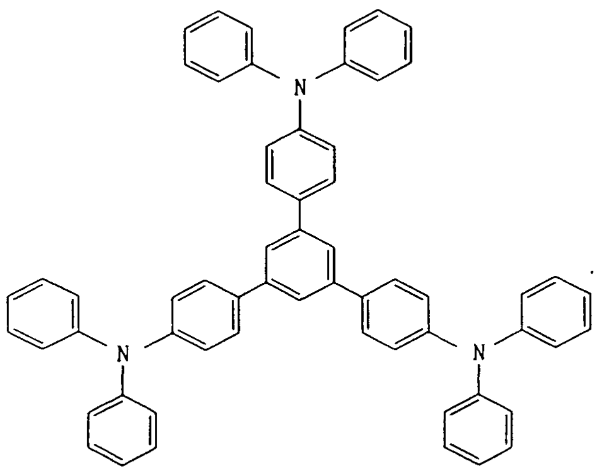

7. The donor film of the low molecular weight full color organic electroluminescent display device of claim 4, wherein the electron injecting layer is formed of one selected from the group consisting of 1,3,4-oxadiazole derivative, 1,2,4-triazole derivative, $Alq_3$, Ga complex, and PBD.

8. The donor film of the low molecular weight full color organic electroluminescent display device of claim 4, wherein the hole blocking layer is formed of one selected from the group consisting of TAZ, spiro-TAZ, compound represented by at least one of the following Formulas 24 to 26:

Formula 24

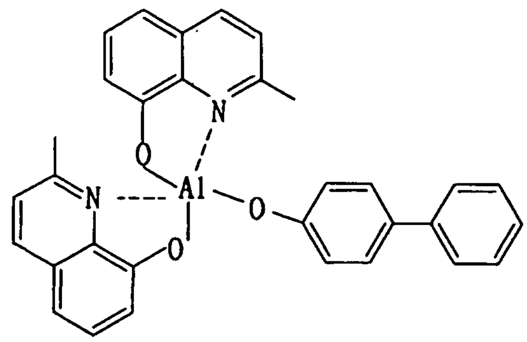

Formula 25

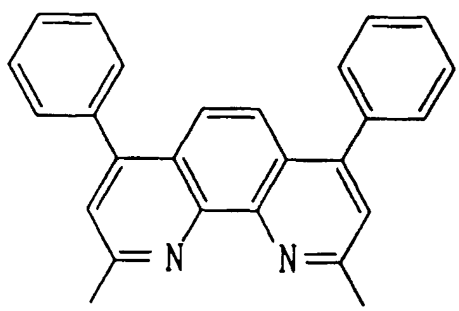

Formula 26

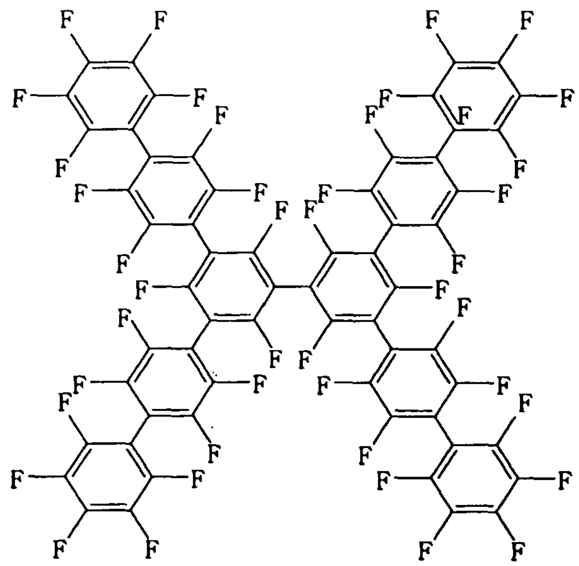

**9.** The donor film of a low molecular weight full color organic electroluminescent display device of claim 1, wherein the photothermal conversion layer comprises a light absorbing material to absorb light in the ultraviolet or visible ray range.

**10.** The donor film of a low molecular weight full color organic electroluminescent display device of claim 1, wherein the photothermal conversion layer comprises a polymer in which a material selected from carbon black, graphite and infrared ray absorbing material is dispersed.

**11.** The donor film of a low molecular weight full color organic electroluminescent display device of claim 1, wherein the substrate film comprises a transparent polymer selected from the group consisting of polycarbonate, polyester, polyethyleneterephthalate, polyethylenenaphthalate, polyestersulfonate, polysulfonate, polyarylate, fluorinated polyimide, fluorinated resin, polyacryl, polyepoxy, polyethylene and polystyrene.

**12.** A method to fabricate a low molecular weight full color organic electroluminescent display device comprising:

forming a first electrode by patterning the first electrode on a substrate;
forming at least one first organic film layer on the first electrode by one of spin coating and a deposition method;
forming an emitting layer to embody full color on a pixel region by a laser induced thermal imaging method;
forming at least one second organic film layer on the emitting layer by one of spin coating and the deposition method; and
forming a second electrode on the second organic film layer/layers.

**13.** The method of claim 12, wherein the at least one first organic film layer comprises one of a hole injection layer and a hole transport layer, and the at least one second organic film layer comprises a layer/layers selected from an electron injection layer, a hole blocking layer and an electron transport layer when the first electrode is an anode electrode.

**14.** The method of claim 13, wherein the at least one first organic film layer comprises a layer/layers selected from an electron transport layer, a hole blocking layer and an electron injection layer, and the at least one second organic film layer comprises one of a hole transport layer and a hole injection layer when the first electrode is the cathode

electrode.

**15.** The method of claim 12, wherein the emitting layer is formed by one of spin coating and depositing a low molecular weight emitting material for red, green and blue colors on a donor film to transmit the emitting material.

**16.** The method of claim 12, wherein the emitting layer consists of single layers of each red, green and blue or multi-stacked organic layer including the emitting material for red, green and blue and/or hole transporting layer and/or electron transporting layer.

**17.** A method to fabricate a low molecular weight full color organic electroluminescent display device comprising:

arranging a donor film comprising a low molecular weight organic thin film material comprising substrate film, a photothermal conversion layer and a low molecular weight organic electroluminescent material layer at a position spaced apart from a substrate at a predetermined distance at a position in which a pixel region of the substrate is formed;
irradiating the donor film by a laser to separate the low molecular weight organic thin film material layer in a region wherein a pixel region is formed from the donor film so that the low molecular weight organic thin film material layer is adhered to the substrate by a first adhesion force, the low molecular weight organic thin film material layer of a region onto which laser is not irradiated is fixed to the photothermal conversion layer by a second adhesion force, and the laser irradiated low molecular weight organic thin film material layer and laser non-irradiated low molecular weight organic thin film material layer are separated with respect to each other to cause mass transition and transfering the low molecular weight organic thin film material layer in the pixel region from the photothermal conversion layer to the substrate due to an adhesive force between laser irradiated low molecular weight organic thin film material layer region and laser non-irradiated low molecular weight organic thin film material layer being weaker than the first and second adhesion forces; and
performing heat treatment after completing transferring the low molecular weight organic thin film material layer in the pixel region.

**18.** The method of claim 17, wherein the low molecular weight organic electroluminescent material layer is at least one compound selected from the following Formulas 1 to 13:

Formula 1

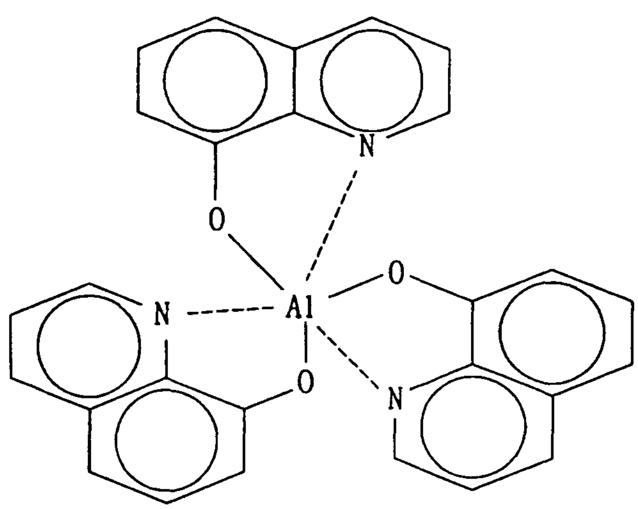

Formula 2

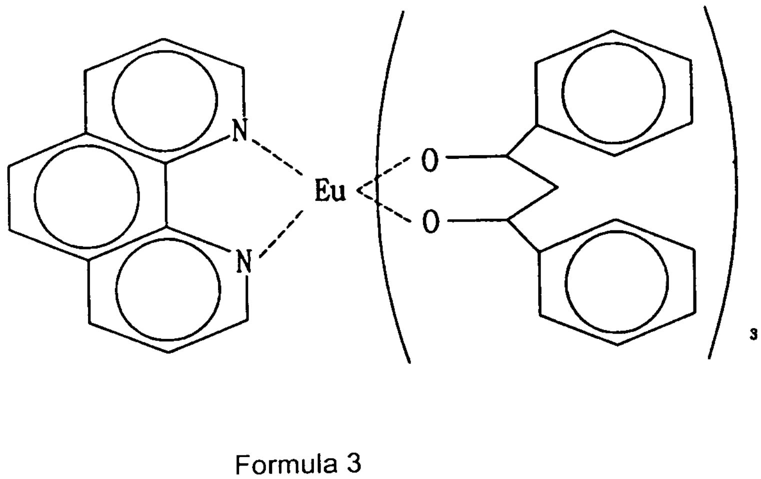

Formula 3

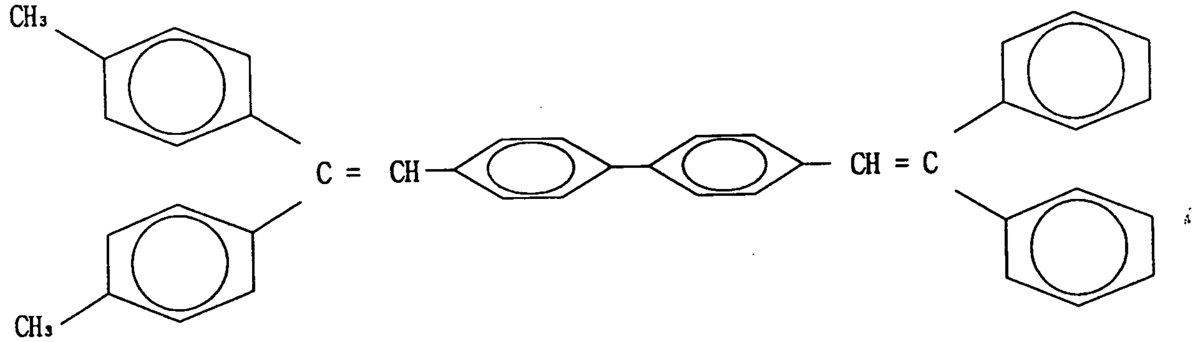

Formula 4

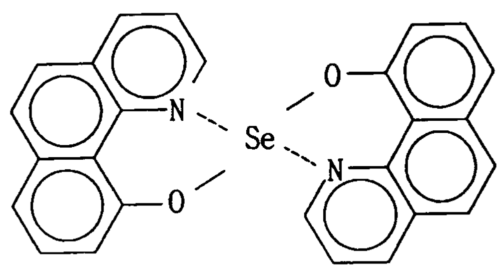

Formula 5

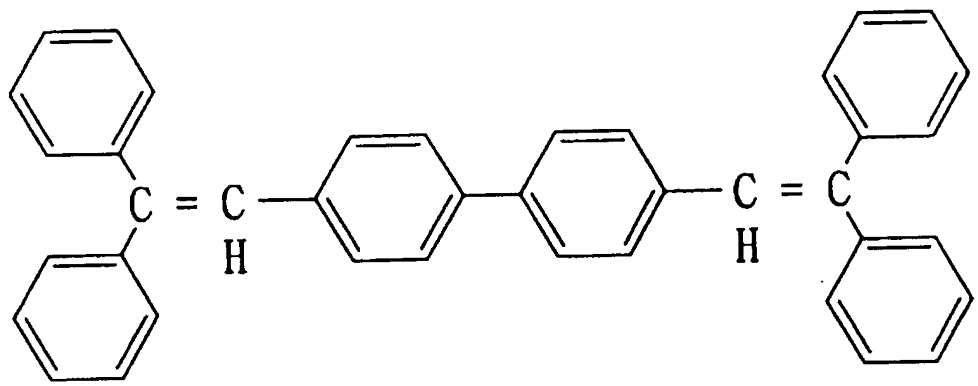

Formula 6

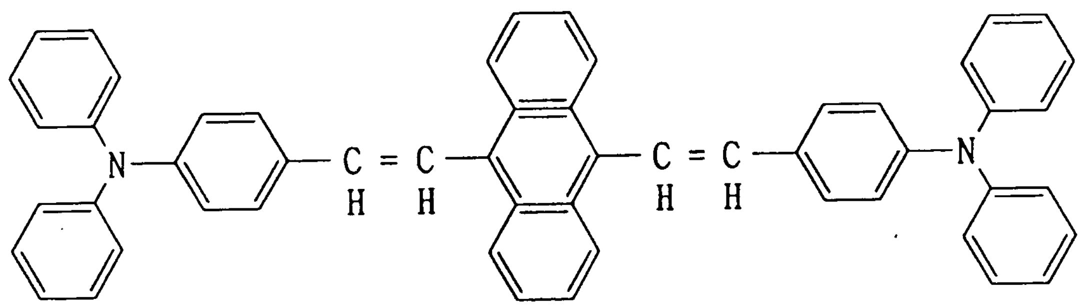

Formula 7

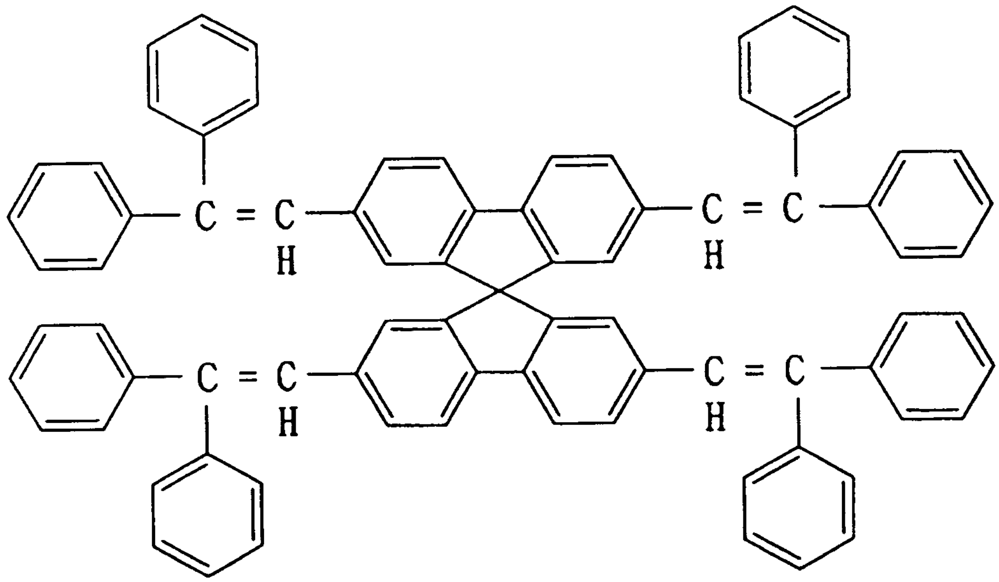

Formula 8

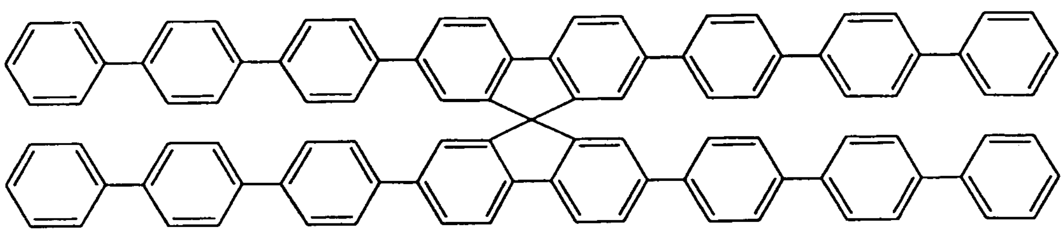

Formula 9

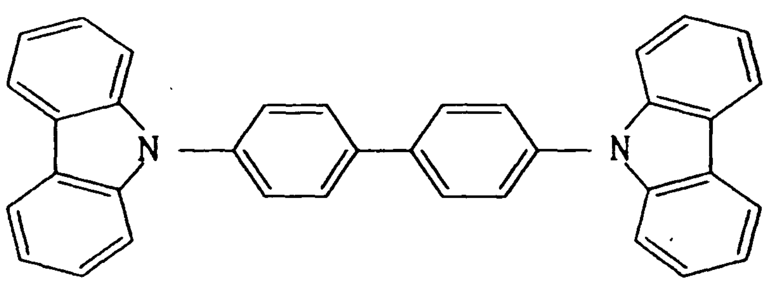

Formula 10

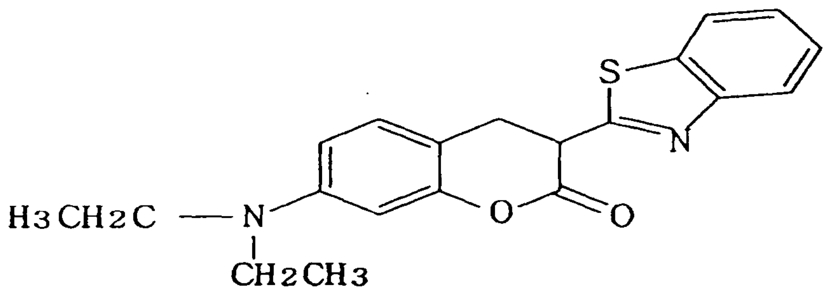

Formula 11

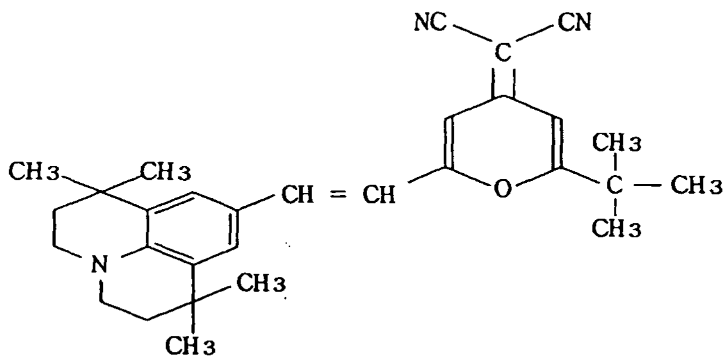

Formula 12

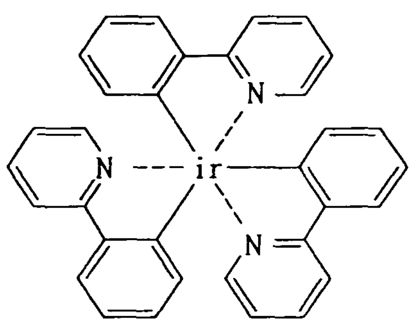

Formula 13

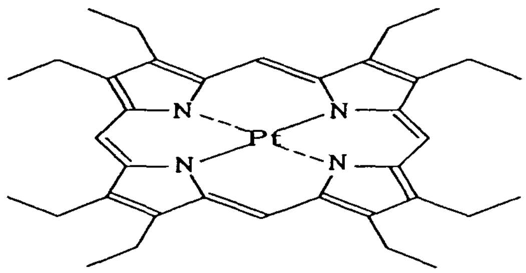

**19.** The method of claim 17, wherein the low molecular weight organic thin film material layer further comprises at least one layer selected from the group consisting of a hole injection layer, a hole transporting layer, a hole blocking layer and an electron transporting layer.

**20.** The method of claim 19, wherein the hole transmitting layer is a compound represented by at least one of the following Formulas 14 to 18:

Formula 14

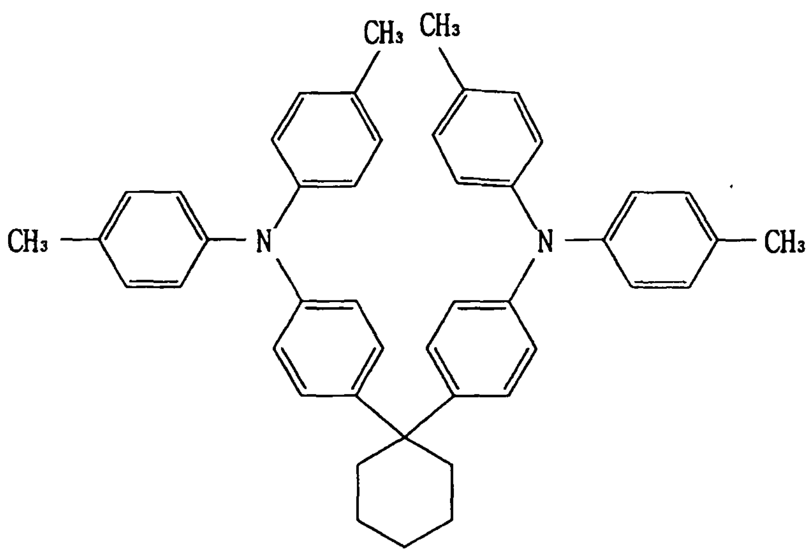

Formula 15

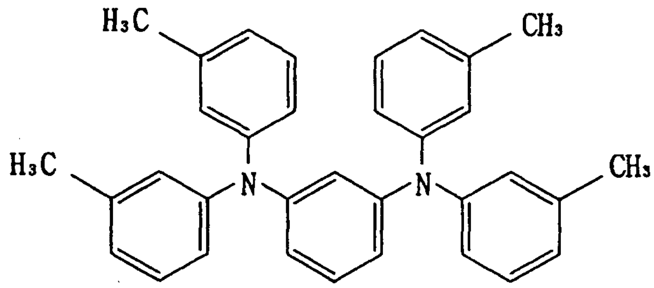

Formula 16

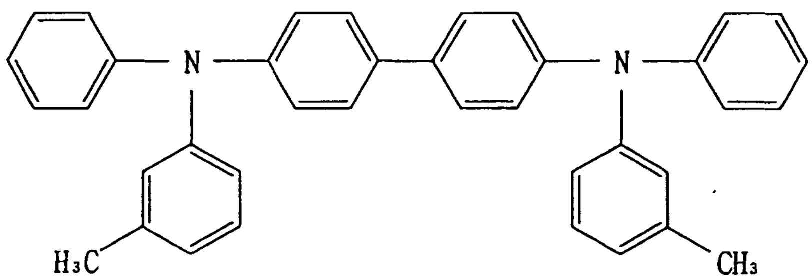

Formula 17

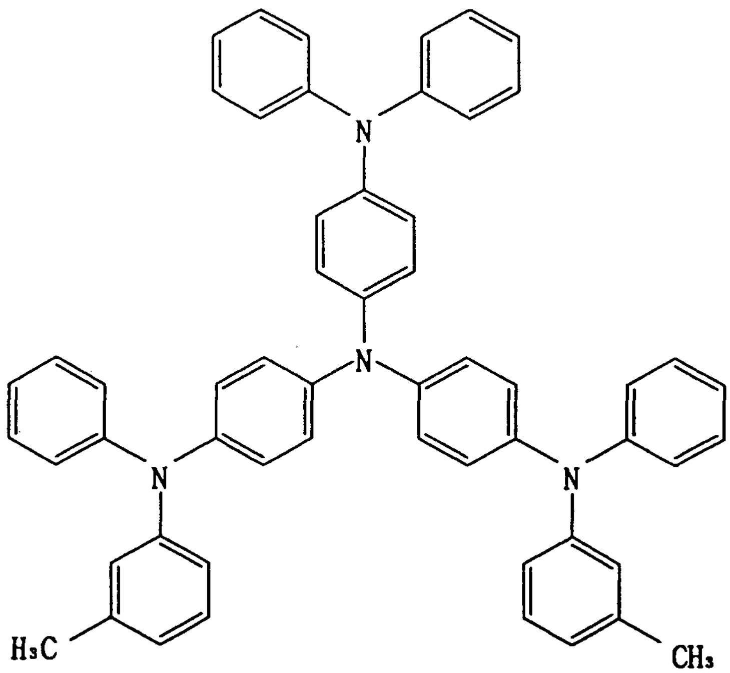

Formula 18

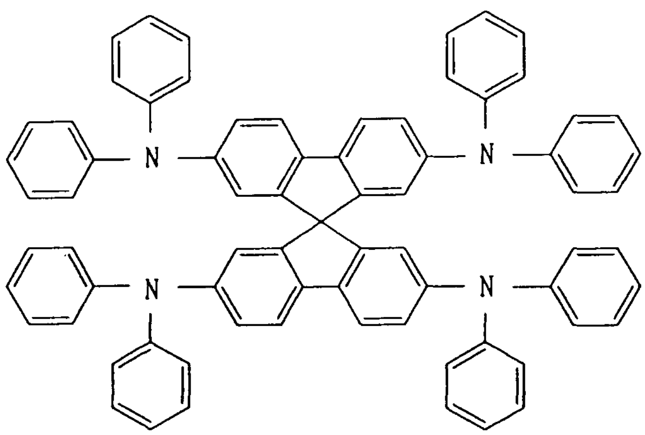

**21.** The method of claim 19, wherein the hole injecting layer is a compound represented by at least one of the following Formulas 19 to 23:

Formula 19

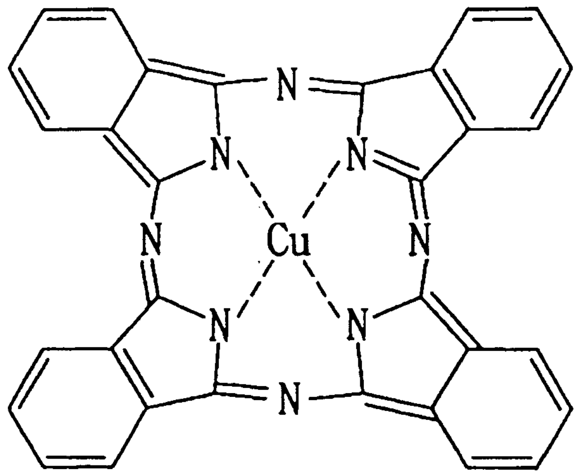

Formula 20

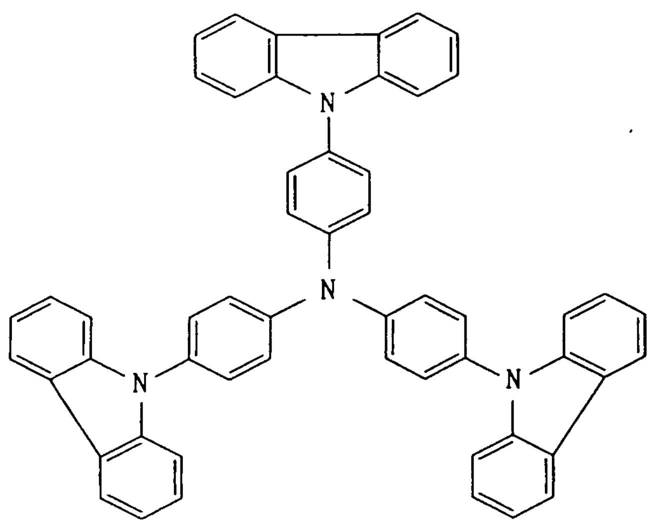

Formula 21

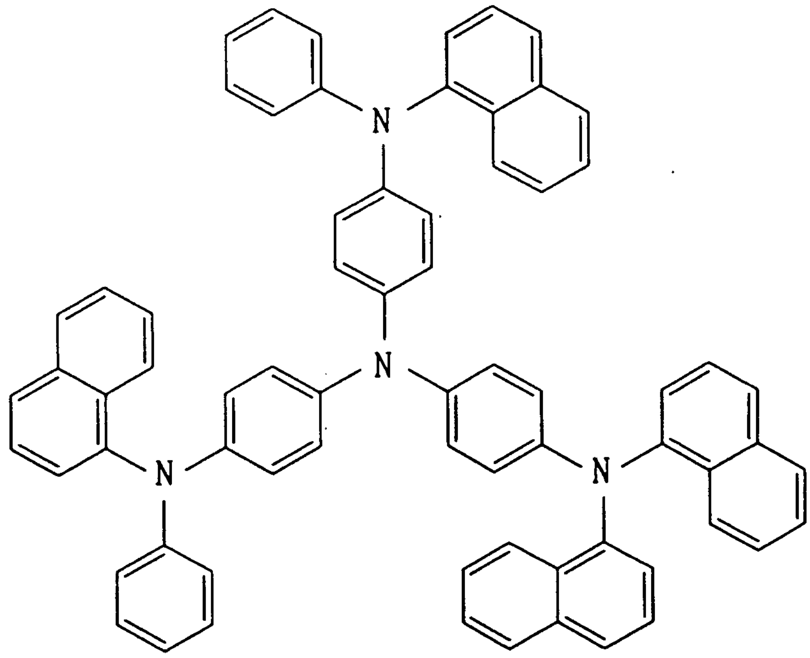

Formula 22

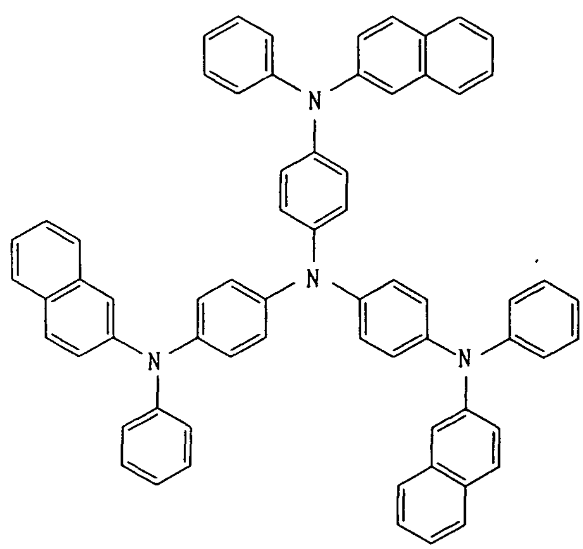

Formula 23

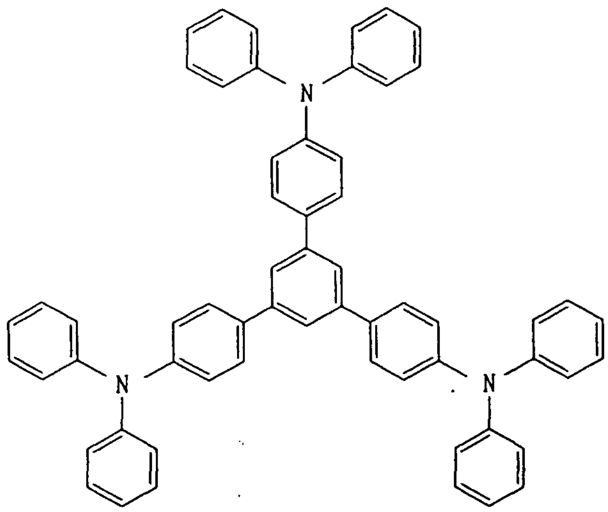

**22.** The method of claim 19, wherein the electron injecting layer is formed of one selected from the group consisting of 1,3,4-oxadiazole derivative, 1,2,4-triazole derivative, $Alq_3$, Ga complex, and PBD.

**23.** The method of claim 19, wherein the hole blocking layer is formed of one selected from the group consisting of TAZ, spiro-TAZ, a compound represented by the following Formulas 24 to 26.

Formula 24

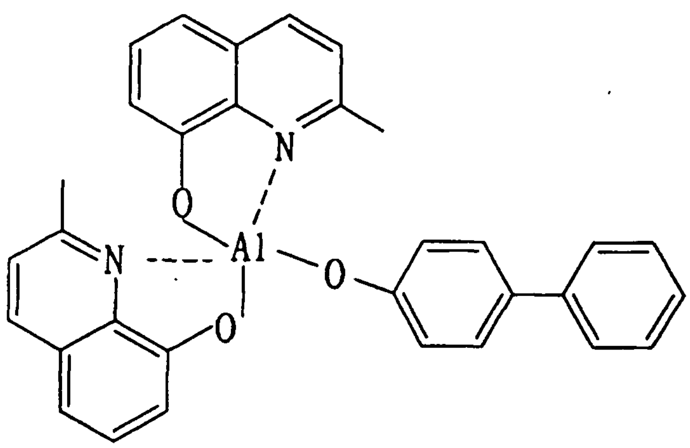

Formula 25

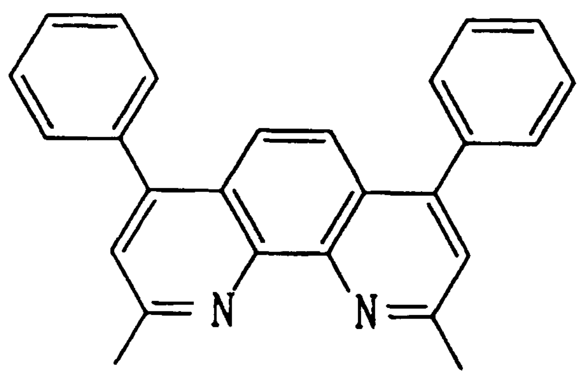

Formula 26

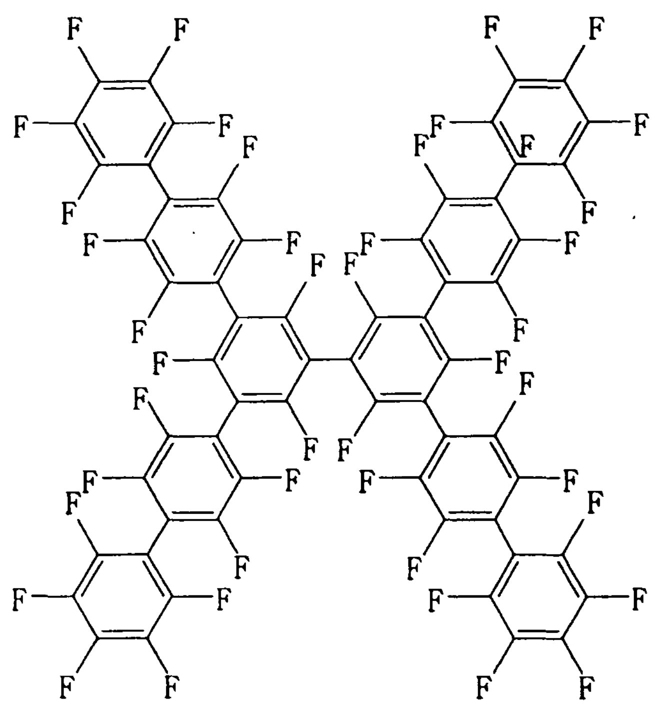

**24.** A low molecular weight full color organic electroluminescent device fabricated by:

forming a first electrode by patterning the first electrode on a substrate;
forming at least one first organic film layer on the first electrode by one of spin coating and a deposition method;
forming an emitting layer to embody full color on a pixel region by a laser induced thermal imaging method;
forming at least one second organic film layer on the emitting layer by one of spin coating and the deposition method; and
forming a second electrode on the second organic film layer/layers.

**25.** A low molecular weight full color organic electroluminescent device fabricated by:

arranging a donor film comprising a low molecular weight organic thin film material comprising substrate film, a photothermal conversion layer and a low molecular weight organic electroluminescent material layer at a position spaced apart from a substrate at a predetermined distance at a position in which a pixel region of the substrate is formed;
irradiating the donor film by a laser to separate the low molecular weight organic thin film material layer in a region wherein a pixel region is formed from the donor film so that the low molecular weight organic thin film material layer is adhered to the substrate by a first adhesion force, the low molecular weight organic thin film material layer of a region onto which laser is not irradiated is fixed to the photothermal conversion layer by a second adhesion force, and the laser irradiated low molecular weight organic thin film material layer and laser non-irradiated low molecular weight organic thin film material layer are separated with respect to each other to cause mass transition and transfering the low molecular weight organic thin film material layer in the pixel region from the photothermal conversion layer to the substrate due to an adhesive force between laser irradiated low molecular weight organic thin film material layer region and laser non-irradiated low molecular weight organic thin film material layer being weaker than the first and second adhesion forces; and
performing heat treatment after completing transferring the low molecular weight organic thin film material layer in the pixel region.

**26.** The donor film of the low molecular weight full color organic display electroluminescent device of claim 1, further including a gas-generating layer, formed in a lower part of the photothermal conversion layer.

**27.** The donor film of the low molecular weight full color organic display electroluminescent device of claim 26, wherein the gas-generating layer is formed of at least one material selected from the group consisting of pentaerythritol tetranitrate and trinitrotoluene.

**28.** The method of claim 17, further including forming a gas-generating layer in a lower part of the photothermal conversion layer.

**29.** The method of claim 28, wherein the gas-generating layer is formed of at least one material selected from the group consisting of pentaerythritol tetranitrate and trinitrotoluene.

FIG. 1

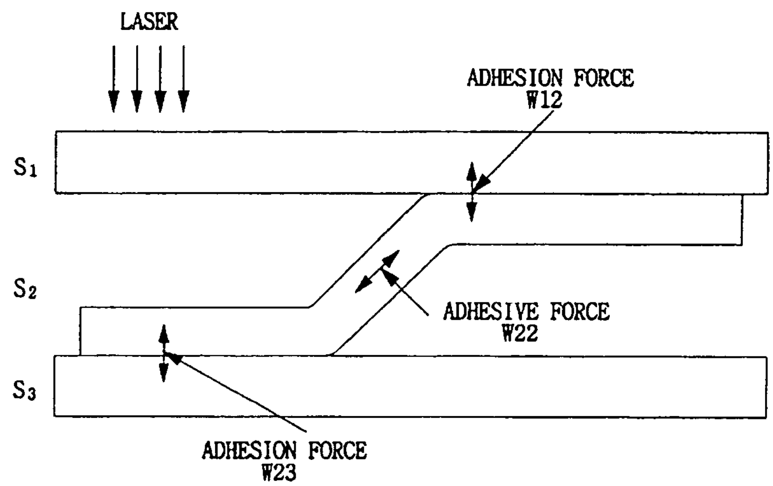
LASER
ADHESION FORCE
W12
S1
S2
ADHESIVE FORCE
W22
S3
ADHESION FORCE
W23

FIG. 2

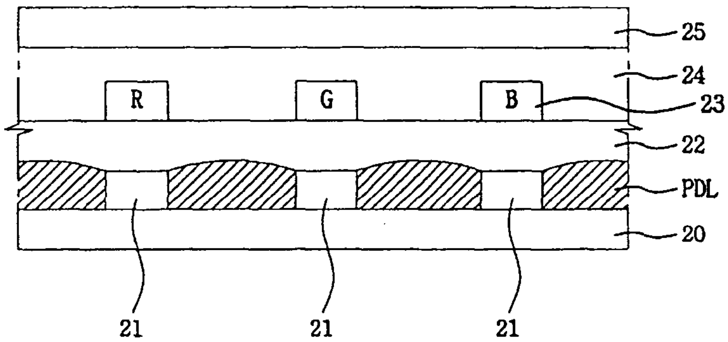


FIG. 3

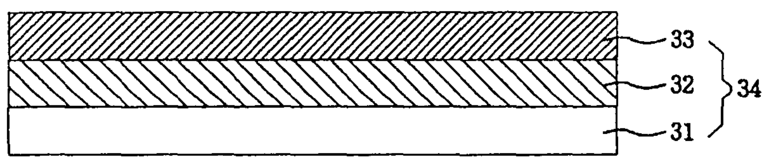


FIG. 4

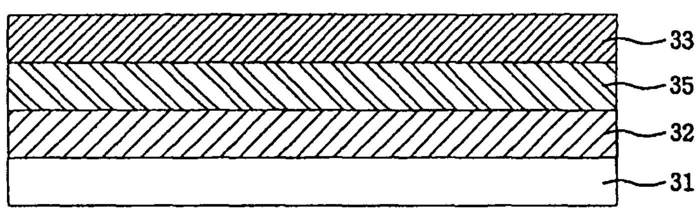

FIG. 5